# EUROPEAN PATENT SPECIFICATION

(11) **EP 0 894 423 B1**
(45) Date of publication and mention of the grant of the patent: **05.01.2005**
(21) Application number: 97917399.4
(22) Date of filing: 16.04.1997
(51) Int. Cl.: H05K 13/04

(54) **MOUNTING ELECTRONIC COMPONENT METHOD AND APPARATUS**
VERFAHREN UND VORRICHTUNG ZUR BESTÜCKUNG VON ELEKTRONISCHEN BAUELEMENTEN
PROCEDE ET APPAREIL DE MONTAGE DE COMPOSANTS ELECTRONIQUES

(30) Priority: 18.04.1996 JP 9577096
(43) Date of publication of application: 03.02.1999
(73) Proprietor: MATSUSHITA ELECTRIC INDUSTRIAL CO., LTD., Kadoma-shi, Osaka 571-8501 (JP)
(72) Inventor: YOSHIDA, Noriaki, Ikeda-shi, Osaka 563 (JP); MIMURA, Yoshihiro, Izumi-shi, Osaka 590-02 (JP); FUKUDA, Shozo, Higashiosaka-shi, Osaka 578 (JP); HATA, Kanji, Katano-shi, Osaka 576 (JP)
(74) Representative: Eisenführ, Speiser & Partner
(86) International application number: PCT/JP1997/001309
(87) International publication number: WO 1997/039613

(56) References cited:
- EP-A- 0 650 319
- "MACHINE VISION TECHNIQUE FOR INCREASING THE INTEGRITY OF CHIP ALIGN-MENT DATA" IBM TECHNICAL DISCLOSURE BULLETIN, vol. 34, no. 10B, 1 March 1992, pages 129-131, XP000302661
- LISTER P ET AL: "NEXT-GENERATION VISION ALGORITHMS FOR SMT ASSEMBLY" ELECTRONIC PACKAGING AND PRODUCTION, vol. 32, no. 2, 1 February 1992, pages 48-50, XP000259206

## Description

### TECHNICAL FIELD

The present invention relates to an electronic component mounting apparatus and a method for mounting electronic components onto boards such as printed boards or boards of liquid crystal displays or plasma display panels by the electronic component mounting apparatus.

### BACKGROUND ART

An electronic component mounting apparatus is generally so constituted as to mount electronic components on printed boards after taking out the components from a feed position by means of nozzles. According to the prior art method for mounting the components as above, a posture of the taken-out component is detected by a recognition device, thereby to recognize the component. A recognition process will be depicted below with reference to the drawings.

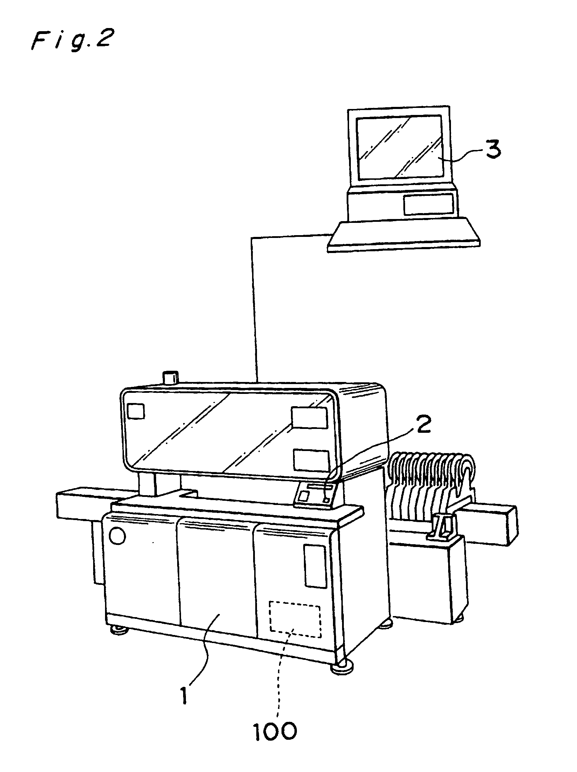

Fig. 2 shows the constitution of an electronic component mounting apparatus provided with a monitoring system for monitoring an operating state of the apparatus. As shown in Fig. 2, the electronic component mounting apparatus is constructed by a main body 1, an operation panel 2 and a host computer 3. An unattended operation has been more and more carried out to improve an operating ratio of the apparatus when mounting the electronic components. A component recognition data required for the mounting apparatus to recognize the electronic components at the mounting time was produced and selected by an operator of the mounting apparatus with the use of the operation panel 2 or host computer 3 simultaneously when a mounting position program was formed.

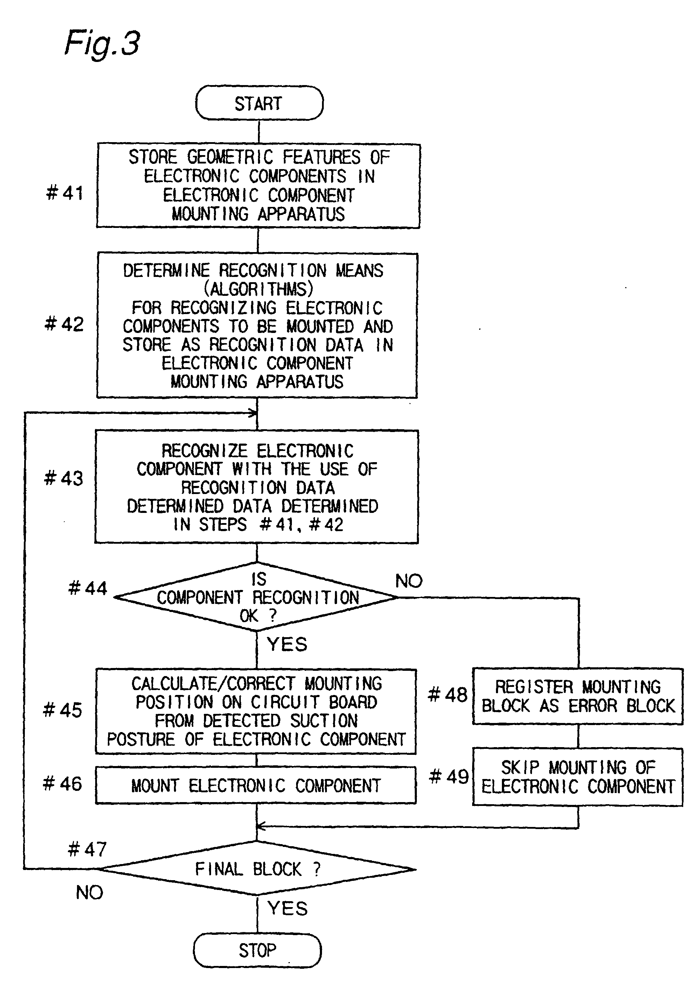

Fig. 3 is a flow chart of procedures for forming and selecting the aforementioned component recognition data in the mounting apparatus utilizing the conventional mounting method. In mounting the electronic components by the mounting apparatus, the operator manipulates the mounting apparatus as follows.

Referring to Fig. 3, based on input of the operator, an outside dimension of an electronic component, a count of leads thereof, a pitch of leads thereof, etc. as geometric features of an electronic component to be mounted are extracted from a catalog data in step #41, and stored in the electronic component mounting apparatus.

In step #42, based on input of the operator, a recognition means (algorithm) supposed to be suitable for the electronic component to be mounted is selected among the means assigned to the electronic component mounting apparatus beforehand. The number of the selected algorithm and the geometric feature inputted in the step #41 are registered and stored in the mounting apparatus as a component recognition data.

In step #43, the electronic component is recognized with the use of the component recognition data registered in steps #41 and #42.

In step #44, it is decided whether or not the component recognition is acceptable (OK or NO).

When it is decided in step #44 that the component recognition is acceptable, a difference between the normal mounting posture at the mounting position of the component on the board and the suction posture of the component detected in step #45 is calculated and corrected.

Next, in step #45, the component is mounted on the board at the corrected mounting position by the mounting apparatus.

Thereafter, in step #47, it is decided whether or not the component to be mounted is left, that is, whether or not a mounting block is last one. When the mounting block is last one, the mounting operation is completed. When the mounting block is not last one, the program returns to step #43 in order to perform the mounting operation of the component in a sequential mounting block.

On the other hand, when the component recognition is not acceptable in step #44, the mounting block to which the component belongs is registered as an error block in step #45.

Next, in step #49, the mounting operation of the component in the mounting block is skipped and thereafter the program goes to step #47.

In such a manner, based on the data taught in the teaching process of steps #41 and #42 through the input of the operator, the mounting process in steps #43 to #47 is performed. In the mounting process, the recognition data of the components in the teaching process are used to confirm the component recognition result and when the confirmed result is acceptable, the selected recognition data is used. When the confirmed result is not acceptable, the mounting operation of the component is skipped and a sequential component mounting operation is performed to carry out a continuous mounting operation.

The prior art mounting method based on the above-described formation/registration method of the component recognition data in the electronic component mounting apparatus has following demerits.
1) In the teaching process of forming/registering the component recognition data in the electronic component mounting apparatus, since the operator identifies and judges the electronic component to be mounted, the component recognition data varies for every operator. As a result, even the same electronic component cannot be mounted with high recognition accuracy.
2) Since only one recognition algorithm is selected and executed for one time of electronic component recognition by the operator in the mounting process, if a surface color is minutely different among lots of electronic components or the electronic components shine differently due to a gloss difference of leads, a recognition efficiency is extremely worsened, leading to an increase of wrong recognitions.

.Machine vision technique for increasing the integrity of chip alignment data", IBM technical disclosure bulletin, vol. 34, no. 10B, 1 March 1992, p. 129-121, XP000302661, discloses a technique which includes several image processing algorithms to verify that C-4 pad images to be used for chip alignment data are good quality images. Moreover, only on posture result of the chip is generated for calculating the chip alignment data.

EP-A-0 650 319 teaches image processing of electronic parts for mounting thereof in detail, but concentrates on extracting parts data from the processed images and does not disclose the use of more than one algorithm for generating posture results of an electronic component to be mounted.

Lester P., "Next-generation vision algorithms for SMT assembly", Electronic Packing and Production, vol. 32, no. 2, 1 February 1992, p. 48-50, XP000259206 discloses parallel processing, in particular with respect to the use of neural-network hard- and software, of images of electronic components for surface mount assembly.

### DISCLOSURE OF INVENTION

Accordingly, an object of the present invention is to provide electronic component mounting method and apparatus whereby electronic components of the same geometric features can be recognized/mounted with high accuracy and high recognition efficiency without setting an algorithm for every electronic component, thereby greatly decreasing wrong recognitions, while eliminating the need for an operator to set/control a component recognition data.

In accomplishing these and other aspects, according to the present invention, there is provided an electronic component mounting method for use with an electronic component mounting apparatus in which an electronic component is taken out from an electronic component feed position, a posture of the taken-out component is detected, and the component is mounted on a board based on a detected result,
the method comprising:
acquiring image data of the component taken-out from the feed position by a camera;
processing acquired image data with a plurality of algorithms for detecting postures of components and
generating a plurality of posture results;
comparing each detected result related to the posture of the component obtained in the plurality of algorithms with geometric features of the component stored in the electronic component mounting apparatus;
thereby selecting one result from the detected results; and
correcting data of a mounting position of the component on the board based on the selected result and mounting the component at the mounting position of the board.

According to an embodiment of the present invention, there is provided an electronic component mounting method as defined in claim 2, wherein in selecting the one result from the detected results, an area value of the component obtained from an outside dimension of the component is compared with an area value of the component obtained from the detected result of the algorithm, thereby to select the result of the one algorithm correctly recognizing the geometric shape of the component.

According to an embodiment of the present invention, there is provided an electronic component mounting method as defined in claim 3, wherein in selecting the one result from the detected results, a length of an outline of the component obtained from an outside dimension of the component is compared with a length of an outline of the component obtained from the detected result of the algorithm, thereby to select the detected result of the one algorithm correctly recognizing the geometric shape of the component.

According to the present invention, there is further provided an electronic component mounting apparatus in which an electronic component is taken out from an electronic component feed position, a posture of the taken-out component is detected, and the component is mounted on a board based on a detected result,
the apparatus comprising:
a camera for acquiring image data of the component taken-out from the feed position;
a control unit for processing acquired image data with a plurality of algorithms for detecting postures of components, and detecting a posture of the taken-out component;
wherein the control unit compares each detected result related to the posture of the component obtained in the plurality of algorithms with geometric features of the component stored in the electronic component mounting apparatus; thereby selects one result from the detected results; and corrects data of a mounting position of the component on the board based on the selected result and controls to mount the component at the mounting position of the board.

According to an embodiment of the present invention, there is provided an electronic component mounting apparatus as defined in claim 6, wherein in selecting the one result from the detected results, the control unit controls so that an area value of the component obtained from an outside dimension of the component is compared with an area value of the component obtained from the detected result of the algorithm, thereby to select the result of the one algorithm correctly recognizing the geometric shape of the component.

According to an embodiment of the present invention, there is provided an electronic component mounting apparatus as defined in claim 7, wherein in selecting the one result from the detected results, the control unit controls so that a length of an outline of the component obtained from an outside dimension of the component is compared with a length of an outline of the component obtained from the detected result of the algorithm, thereby to select the detected result of the one algorithm correctly recognizing the geometric shape of the component.

According to the aspects of the present invention, positional data for mounting of electronic component is calculated and stored based on the posture of the electronic component detected by the recognition process and geometric features of the electronic component held, such as being stored, in an electronic component mounting apparatus. An algorithm for detecting postures of components is not set for each one of the electronic components of the same geometric features. The electronic components can be recognized/mounted with high accuracy and high recognition efficiency. A count of wrong recognitions of components is greatly reduced and the need for the operator to set/control the component recognition data is eliminated.

In the above-described method, when the taken-out posture of the electronic component from the feed position by the nozzle or a chuck to be mounted onto the printed board or display panel boards is detected by the recognition process, the image of the electronic component is processed with the use of a plurality of algorithms for detecting postures of components. Each result is then compared with the held-, such as stored-, geometric features of the electronic component, and one is selected from a plurality of results. The data of the mounting position of the electronic component is corrected based on the selected result.

### BRIEF DESCRIPTION OF DRAWINGS

These and other aspects and features of the present invention will become clear from the following description taken in conjunction with the preferred embodiments thereof with reference to the accompanying drawings, in which:
Fig. 1 is a flow chart of procedures for recognizing components in an electronic component mounting method of an embodiment of the present invention;
Fig. 2 is a schematic view of the constitution of an electronic component mounting apparatus utilizing the electronic component mounting method of the embodiment;
Fig. 3 is a flow chart of procedures for recognizing components according to a conventional electronic component mounting method; and
Fig. 4 is a block diagram of a recognition device of the apparatus of the embodiment.

### BEST MODE FOR CARRYING OUT THE INVENTION

Before the description of the present invention proceeds, it is to be noted that like parts are designated by like reference numerals throughout the accompanying drawings.

Electronic component mounting method and apparatus in one embodiment of the present invention will be specifically described with reference to the drawings.

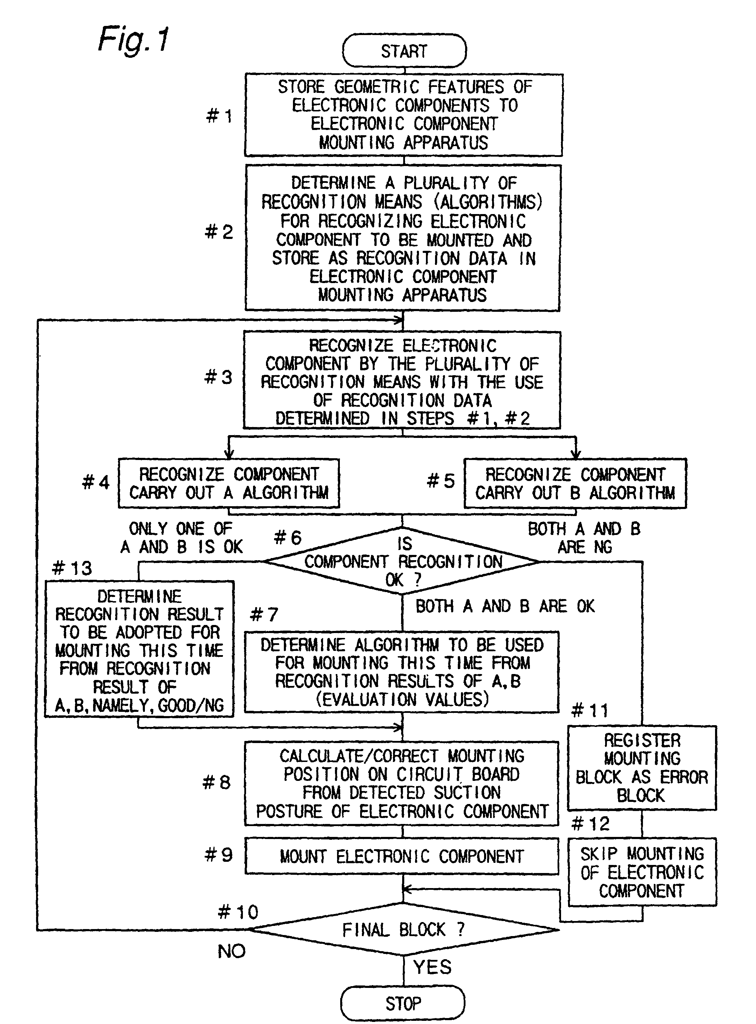

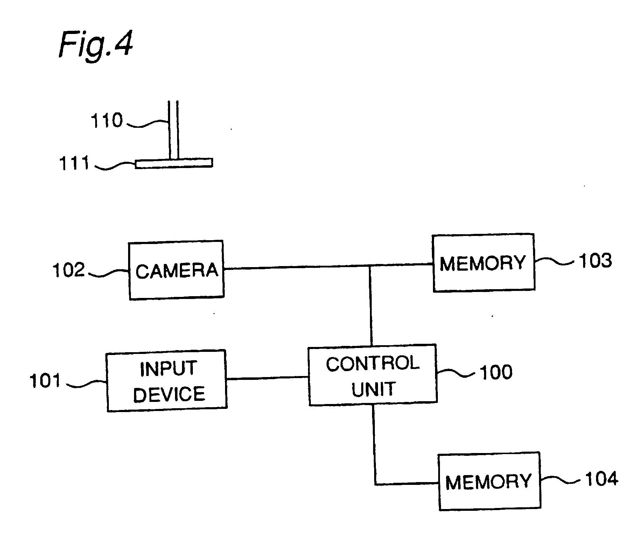

Fig. 1 is a flow chart of procedures for forming a component recognition data when an electronic component is mounted in the application of the electronic component mounting method of the embodiment, and for recognizing the electronic component with the use of the data. Fig. 4 is a block diagram of a recognition device of the apparatus for carrying out the method.

In step #1 in Fig. 1, outside dimensions, counts of leads, pitches of leads, etc. of electronic components are extracted as geometric features of the electronic components to be mounted from a catalog data, and then the geometric features are stored in a memory 104 of a recognition device 150 of the electronic component mounting apparatus, with an input device 101 such as a keyboard or a mouse through operations of an operator.

In step #2, through the input of the operator, a plurality of candidates for a recognition means (algorithms for detecting postures of the electronic components) preliminarily assigned to the mounting apparatus and supposed to be suitable to the electronic components to be mounted are selected in accordance with numbers of leads and colors of packages of the components, and then registered as a component recognition data in the memory 104 of the recognition device 150 in the mounting apparatus.

In step #3, the electronic component is mounted by the mounting apparatus with the use of the component recognition data registered in steps #1, #2. In this step, image data of the electronic component 111 sucked by a nozzle 110 of the mounting apparatus is acquired by a camera 102, the image data is stored in each of a plurality of internal memory sections of the memory 103 of the recognition device 150 inside of the mounting apparatus.

Next, in steps #4 and #5, the image data of the component respectively stored in the memory sections are processed with different algorithms stored in the memory 104 and selected in step #2 by the control unit 100 of the recognition device 150 at the same time. In order to perform these processing, the control unit 100 has processing components for performing respective processing. As one example, in Fig. 1, the image data is processed by executing an algorithm of A in step #4 at the same time as the image data is processed by executing an algorithm of B in step #5.

In step #6, each of recognition results of the electronic component with the use of the plurality of algorithms selected in step #3 and executed in steps #4 and #5 is compared with geometric features of the electronic component stored in step #1, by the control unit 100, thereby to evaluate the recognition results.

In such a manner, the recognition device 150 of the mounting apparatus is generally constructed by the camera 102, the memories 103 and 104, the control unit 100, and the input device 101.

The plurality of recognition algorithms are executed to recognize the electronic component in steps #4 and #5. Therefore, a plurality of different recognition results are given back from the recognition device 150, making it necessary to select an optimum recognition result among the plurality of recognition results in accordance with an evaluation value by the control unit 100.

For calculating the above evaluation value, in one way, an area value of the electronic component obtained from the outside dimension is compared with an area value of the electronic component obtained from the recognition result, thereby to select the algorithm correctly recognizing the geometric shape of the electronic component. In a different way, a length of an outline of the electronic component obtained from the outside dimension of the electronic component is compared with a length of the outline of the electronic component obtained from the recognition result, thereby to select the algorithm correctly recognizing the geometric shape of the electronic component.

In the manner as above, in step #6, an optimum recognition result is selected among the plurality of recognition results of the algorithms.

As one example, when the recognition results of the algorithms of A and B respectively executed in steps #4 and #5 are fallen within an allowable range in step #6, the program goes to step #7 in which based on the component recognition evaluation values calculated from the two recognition results, one algorithm using at this time is selected among the plural algorithms.

Next, in step #8, based on the recognition result of the selected algorithm, a mounting position on the board is calculated from the suction posture of the detected component and corrected by the control unit 100.

In step #9, based on the corrected mounting position, the component is mounted on the board by using the mounting apparatus under the control of the control unit 100.

Thereafter, in step #10, it is decided whether or not the component to be mounted is left, that is, whether or not a mounting block is last one. When the block is last one, the mounting operation is completed. When the block is not last one, the program returns to step #3 in order to perform the mounting operation of the component in a sequential mounting block.

On the other hand, when either one of the recognition results of the algorithms of A and B is fallen within the allowable range in step #6, it is determined that one algorithm having the allowable recognition result is selected among the two algorithms in step #13 and the program goes to step #8.

When both of the recognition results of the algorithms of A and B are not fallen within the allowable range in step #6, the mounting block to which the component belongs is registered as an error block in step #11. Next, in step #12, the mounting operation of the component in the mounting block is skipped and thereafter the program goes to step #10.

In such a manner, based on the data taught in the teaching process of steps #1 and #2 through the input of the operator, the mounting process in steps #3 to #10 is performed. In the mounting process, the recognition data of the components in the teaching process are used to confirm the recognition results and when the confirmed result is acceptable, the selected recognition data is used. When the confirmed result is not acceptable, the mounting operation of the component is skipped and perform a sequential component mounting operation to carry out a continuous mounting operation.

In the manner as above, when a posture of the electronic component taken out by the nozzle from a feed position to be mounted onto a printed board is detected by the recognition device, an image of the electronic component is processed in a plurality of steps with the use of the plurality of algorithms for detecting postures. Each result is compared with the stored geometric features of the electronic component and one is selected from the plurality of detection results. A mounting position of the electronic component is thus corrected based on the selected detection result.

According to the method, while the algorithm is not set for each of the electronic components of the same geometric features, the electronic components can be recognized/mounted with high accuracy and high recognition efficiency, so that the number of wrong recognitions to the electronic components is remarkably reduced. At the same time, it becomes unnecessary for the operator to set/control the component recognition data.

In consequence, the operator is freed from the need to limit one component recognition data for every electronic component in order to form and register the component recognition data in the electronic component mounting apparatus. The component recognition data of the electronic components of the same geometric features becomes uniform, not irregular. Even if the electronic components show a minute difference in surface color because of irregularities among production lots of the electronic components or shine differently due to a gloss difference of leads, etc., the recognition efficiency is prevented from being deteriorated large, and the recognition accuracy is improved.

As the above-described algorithms for detecting postures, are devised various kinds of algorithms such as in U.S. Patent No. 4,981,372 issued to Morimoto, et. al. on January 1, 1991 and U.S. Patent No. 5,038,380 issued to Morimoto, et. al. on August 6, 1991 as examples.

As described hereinabove, according to the present invention, when the posture of the electronic component taken out from the feed position to be mounted onto the board is detected by the recognition device, the image of the electronic component is processed with the use of a plurality of algorithms for detecting postures, and one result is selected from a plurality of detection results. The mounting positional data of the electronic component is corrected based on the selected result.

Accordingly, the electronic components of the same geometric features are recognized and mounted with high accuracy and high recognition efficiency without setting the algorithm for every electronic component. The electronic components can be prevented from being recognized wrong and the operator is not required to set and control the component recognition data.

The operator is not necessary to limit one component recognition data for each electronic component to form and register the component recognition data in the electronic component mounting apparatus. Even when the electronic components show a delicate difference in surface color due to irregularities among production lots of the electronic components or shine differently due to a difference in luster of leads, the recognition efficiency is not worsened extraordinarily and the recognition accuracy is improved.

Finally, the present invention has been fully described in connection with the preferred embodiments thereof with reference to the accompanying drawings, it is to be noted that various changes and modifications are apparent to those skilled in the art.

## Claims

1. An electronic component mounting method for use with an electronic component mounting apparatus (1, 2, 3) in which an electronic component (111) is taken out from an electronic component feed position, a posture of the taken-out component (111) is detected, and the component (111) is mounted on a board based on a detected result,
the method comprising:
acquiring image data of the component (111) taken-out from the feed position by a camera (102);
processing acquired image data with a plurality of algorithms for detecting postures of components (111) and generating a plurality of posture results;
comparing each detected result related to the posture of the component (111) obtained in the plurality of algorithms with geometric features of the component (111) stored in the electronic component mounting apparatus (1, 2, 3);
thereby selecting one result form the detected results; and
correcting data of a mounting position of the component (111) on the board based on the selected result and mounting the component (111) at the mounting position of the board.

2. The electronic component mounting method as defined in claim 1, wherein in selecting the one result from the detected results, an area value of the component (111) obtained from an outside dimension of the component (111) is compared with an area value of the component (111) obtained from the detected result of the algorithm, thereby to select the result of the one algorithm correctly recognizing the geometric shape of the component (111).

3. The electronic component mounting method as defined in claim 1, wherein in selecting the one result from the detected results, a length of an outline of the component (111) obtained from an outside dimension of the component (111) is compared with a length of an outline of the component (111) obtained from the detected result of the algorithm, thereby to select the detected result of the one algorithm correctly recognizing the geometric shape of the component (111).

4. The electronic component mounting method, as defined in claims 1 to 3, wherein said processing of the image date with a plurality of algorithms includes processing the image data concurrently with the plurality of algorithms.

5. An electronic component mounting apparatus (1, 2, 3) in which an electronic component (111) is taken out from an electronic component feed position, a posture of the taken-out component (111) is detected, and the component (111) is mounted on a board based on a detected result,
the apparatus (1, 2, 3) comprising:
a camera (102) for acquiring image data of the component (111) taken-out from the feed position; and
a control unit (100) for processing acquired image data with a plurality of algorithms for detecting postures of components (111), and generating a plurality of posture results;
wherein the control unit (100) compares each detected result related to the posture of the component (111) obtained in the plurality of algorithms with geometric features of the component (111) stored in the electronic component mounting apparatus (1, 2, 3); thereby selects one result from the detected results; and corrects data of a mounting position of the component (111) on the board based on the selected result and controls to mount the component (111) at the mounting position of the board.

6. The electronic component mounting apparatus as defined in claim 5, wherein in selecting the one result form the detected results, the control unit (100) controls so that an area value of the component (111) obtained from an outside dimension of the component (111) is compared with an area value of the component (111) obtained from the detected result of the algorithm, thereby to select the result of the one algorithm correctly recognizing the geometric shape of the component (111).

7. The electronic component mounting apparatus as defined in claim 5, wherein in selecting the one result from the detected results, the control unit (100) controls so that a length of an outline of the component (111) obtained from an outside dimension of the component (111) is compared with a length of an outline of the component (111) obtained from the detected result of the algorithm, thereby to select the detected result of the one algorithm correctly recognizing the geometric shape of the component (111).

## Patentansprüche

1. Bestückungsverfahren für elektronische Bauteile zur Verwendung mit einer Bestückungsvorrichtung (1, 2, 3), in der ein elektronisches Bauteil (111) aus einer Zuführposition für elektronische Bauteile aufgenommen, eine Positur des aufgenommenen Bauteils (111) erfasst und das Bauteil (111) auf einer Schaltungsplatine auf Basis eines erfassten Ergebnisses montiert wird,
wobei das Verfahren die folgenden Schritte enthält:
Erfassen von Bilddaten des aus der Zuführposition aufgenommenen Bauteils (111) durch eine Kamera (102);
Verarbeiten der erfassten Bilddaten mit einer Vielzahl von Algorithmen zum Erfassen der Posituren der Bauteile (111) und Erzeugen einer Reihe von Positurergebnissen;
Vergleichen jedes erfassten Ergebnisses, welches die Positur des Bauteils (111) betrifft und welches durch die Vielzahl von Algorithmen erhalten worden ist, mit geometrischen Merkmalen des Bauteils (111), die in der Bestückungsvorrichtung (1, 2, 3) für elektronische Bauteile gespeichert sind;
dabei Auswählen eines Ergebnisses aus den erfassten Ergebnissen; und
Korrigieren der Daten der Montageposition des Bauteils (111) auf der Schaltungsplatine auf Basis des ausgewählten Ergebnisses und Montieren des Bauteils (111) in der Montageposition der Schaltungsplatine.

2. Bestückungsverfahren für elektronische Bauteile nach Anspruch 1, wobei beim Auswählen des einen Ergebnisses aus den erfassten Ergebnissen ein Flächenwert des Bauteils (111), welcher aus Außenabmessungen des Bauteils (111) erhalten worden ist, mit einem Flächenwert des Bauteils (111), der aus dem erfassten Ergebnis des Algorithmus erhalten worden ist, verglichen wird, um dadurch das Ergebnis des einen Algorithmus, der die geometrische Form des Bauteils (111) richtig erkennt, auszuwählen.

3. Bestückungsverfahren für elektronische Bauteile nach Anspruch 1, bei dem beim Auswählen des einen Ergebnisses aus den erfassten Ergebnissen eine Länge einer Außenlinie des Bauteils (111), die aus einer Außenabmessung des Bauteils (111) erhalten worden ist, mit einer Länge einer Außenlinie des Bauteils (111), die aus dem erfassten Ergebnis des Algorithmus erhalten worden ist, verglichen wird, um dadurch das erfasste Ergebnis des einen Algorithmus, welches die geometrische Form des Bauteils (111) richtig erkennt, auszuwählen.

4. Bestückungsverfahren für elektronische Bauteile nach den Ansprüchen 1 bis 3, wobei der Schritt des Verarbeitens der Bilddaten mit einer Vielzahl von Algorithmen das gleichzeitige Verarbeiten der Bilddaten mit der Vielzahl von Algorithmen enthält.

5. Bestückungsvorrichtung (1, 2, 3) für elektronische Bauteile, in der ein elektronisches Bauteil (111) aus einer Zuführposition für elektronische Bauteile aufgenommen, eine Positur des aufgenommenen Bauteils (111) erfasst und das Bauteil (111) auf einer Schaltungsplatine auf Basis eines erfassten Ergebnisses montiert wird,
wobei die Vorrichtung (1, 2, 3) enthält:
eine Kamera (102) zum Erfassen von Bilddaten des aus der Zuführposition aufgenommenen Bauteils (111); und
eine Steuereinheit (100), um die erfassten Bilddaten mit einer Vielzahl von Algorithmen zum Erfassen von Posituren der Bauteile (111) zu verarbeiten und um eine Vielzahl von Positurergebnissen zu erzeugen;
wobei die Steuereinheit (100) jedes erfasste Ergebnis, welches die Positur des Bauteils (111) betrifft und welches durch die Vielzahl von Algorithmen erhalten worden ist, mit geometrischen Merkmalen des Bauteils (111), die in der Bestückungsvorrichtung (1, 2, 3) für elektronische Bauteile gespeichert sind, vergleicht, wobei die Steuereinheit (100) dabei ein Ergebnis aus den erfassten Ergebnissen auswählt und wobei die Steuereinheit (100) die Daten der Montageposition des Bauteils (111) auf der Schaltungsplatine auf Basis des ausgewählten Ergebnisses korrigiert und die Montage des Bauteils (111) an der Montageposition der Schaltungsplatine steuert.

6. Bestückungsvorrichtung für elektronische Bauteile nach Anspruch 5, bei der beim Auswählen des einen Ergebnisses aus den erfassten Ergebnissen die Steuereinheit (100) so steuert, dass ein Flächenwert des Bauteils (111), der aus Außenabmessungen des Bauteils (111) erhalten worden ist, mit einem Flächenwert des Bauteils (111), der aus dem erfassten Ergebnis des Algorithmus erhalten worden ist, verglichen wird, um dadurch das Ergebnis des einen Algorithmus, welcher die geometrische Form des Bauteils (111) richtig erkennt, auszuwählen.

7. Bestückungsvorrichtung für elektronische Bauteile nach Anspruch 5, bei der beim Auswählen des einen Ergebnisses aus den erfassten Ergebnissen die Steuereinheit (100) so steuert, dass die Länge einer Außenlinie des Bauteils (111), die aus einer Außenabmessung des Bauteils (111) erhalten worden ist, mit der Länge einer Außenlinie des Bauteils (111), welche aus dem erfassten Ergebnis des Algorithmus erhalten worden ist, verglichen wird, um dadurch das erfasste Ergebnis des einen Algorithmus, welcher die geometrische Form des Bauteils (111) richtig erkennt, auszuwählen.

## Revendications

1. Procédé de montage de composants électroniques à utiliser avec une machine à équiper les plaques imprimées (1, 2, 3) dans laquelle un composant électronique (111) est pris à partir d'une position d'amenée, la posture du composant (111) pris étant détectée et le composant (111) étant monté sur la plaque imprimée selon le résultat de détection,
le procédé comprenant les opérations suivantes:
acquisition de données-image du composant (111) pris à partir d'une position d'amenée, à l'aide d'un appareil photographique (102);
traitement des données-image par application de plusieurs algorithmes afin de détecter la posture du composant (111 ) et génération de plusieurs résultats de posture;
comparaison de chaque résultat de détection concernant la posture du composant (111) obtenu par application de plusieurs algorithmes avec les caractéristiques géométriques du composant (111) mémorisés dans la machine à équiper les plaques imprimées (1, 2, 3);
sélectionnant un résultat parmi les résultats de détection; et
corrigeant les données de la position de montage du composant (111) sur la plaque imprimée selon le résultat sélectionné et montage du composant (111) dans la position de montage sur la plaque imprimée.

2. Procédé de montage de composants électroniques selon la revendication 1,
selon lequel, en sélectionnant un seul résultat parmi les résultats de détection, une valeur de surface du composant (111) obtenue à partir de la dimension extérieure du composant (111) est comparée avec la valeur de surface du composant (111) obtenue à partir du résultat détecté de l'algorithme afin de sélectionner le résultat de l'algorithme reconnaissant la forme géométrique du composant (111) correctement.

3. Procédé de montage de composants électroniques selon la revendication 1,
selon lequel, en sélectionnant un résultat parmi les résultats de détection, la longueur d'un contour du composant (111) obtenue à partir d'une dimension extérieure du composant (111) est comparée avec la longueur d'un contour du composant (111) obtenue à partir du résultat détecté de l'algorithme afin de sélectionner le résultat détecté de l'algorithme reconnaissant la forme géométrique du composant (111) correctement.

4. Procédé de montage de composants électroniques selon les revendications 1 à 3,
selon lequel le traitement des données-image par application de plusieurs algorithmes comprend le traitement simultané des données-image par application des plusieurs algorithmes.

5. Machine à équiper les plaques imprimées (1, 2, 3) dans laquelle un composant électronique (111) est pris à partir d'une position d'amenée du composant électronique, la posture du composant (111) pris étant détectée et le composant (111) étant monté sur une plaque imprimée selon le résultat de détection,
la machine (1, 2, 3) comprenant
un appareil photographique (102) pour acquérir des données-image du composant (111) pris à partir d'une position d'amenée; et
une unité de commande (100) pour traiter les données-image acquises par application de plusieurs algorithmes afin de détecter les postures des composants (111) et générer plusieurs résultats de posture,
l'unité de commande (100) comparant chacun des résultats détectés concernant la posture du composant (111) obtenus par application des plusieurs algorithmes, avec les caractéristiques géométriques du composant (111) mémorisées dans la machine à équiper les plaques imprimées (1, 2, 3), sélectionnant un résultat parmi les résultats de détection, corrigeant les données de la position de montage du composant (111) sur la plaque imprimée à partir du résultat sélectionné et commandant le montage du composant (111) dans sa position de montage sur la plaque imprimée.

6. Machine à équiper les plaques imprimées selon la revendication 5, dans laquelle l'unité de commande (100), en sélectionnant le résultat approprié parmi les résultats de détection, effectue la commande de manière à comparer la valeur de surface du composant (111) obtenue à partir d'une dimension extérieure du composant (111) avec la valeur de surface du composant (111) obtenue à partir du résultat de détection de l'algorithme, afin de sélectionner le résultat de l'algorithme même reconnaissant la forme géométrique du composant (111) correctement.

7. Machine à équiper les plaques imprimées selon la revendication 5, dans laquelle l'unité de commande (100), en sélectionnant le résultat approprié parmi les résultats de détection, effectue la commande de manière à comparer la longueur d'un contour du composant (111) obtenue à partir d'une dimension extérieure du composant (111) avec la longueur d'un contour du composant (111) obtenue à partir du résultat de détection de l'algorithme, afin de sélectionner le résultat de détection de l'algorithme reconnaissant la forme géométrique du composant (111) correctement.
